# EUROPEAN PATENT SPECIFICATION

(11) **EP 1 632 994 B1**
(45) Date of publication and mention of the grant of the patent: **16.12.2009**
(21) Application number: 04745450.9
(22) Date of filing: 31.05.2004
(51) Int. Cl.: H01L 21/31, H01J 37/32

(54) **PLASMA PROCESSING APPARATUS AND PLASMA PROCESSING METHOD**
PLASMAVERARBEITUNGSVORRICHTUNG UND PLASMAVERARBEITUNGSVERFAHREN
DISPOSITIF ET PROCEDE DE TRAITEMENT AU PLASMA

(30) Priority: 29.05.2003 JP 2003152808
(43) Date of publication of application: 08.03.2006
(73) Proprietor: TOKYO ELECTRON LIMITED, Minato-ku Tokyo 107-6325 (JP)
(72) Inventor: NOZAWA, Toshihisa, c/o TOKYO ELECTRON LIMITED, Amagasaki-shi, Hyogo 660-0891 (JP); ISHIBASHI, Kiyotaka, c/o TOKYO ELECTRON LIMITED, Amagasaki-shi, Hyogo 660-0891 (JP); NAKANISHI, Toshio, c/o TOKYO ELECTRON LIMITED, Amagasaki-shi, Hyogo 660-0891 (JP)
(74) Representative: HOFFMANN EITLE
(86) International application number: PCT/JP2004/007485
(87) International publication number: WO 2004/107430

(56) References cited:
- GB-A- 2 349 506
- JP-A- 9 055 376
- JP-A- 11 074 251
- JP-A- 2000 269 194
- JP-A- 2000 294 550
- JP-A- 2003 037 105
- JP-A- 2003 133 298
- DATABASE WPI Section Ch, Week 200022 Derwent Publications Ltd., London, GB; Class L03, AN 2000-249337 XP002394348 -& JP 2000 058292 A (MATSUSHITA ELECTRONICS CORP) 25 February 2000 (2000-02-25) & PATENT ABSTRACTS OF JAPAN vol. 2000, no. 05, 14 September 2000 (2000-09-14) & JP 2000 058292 A (MATSUSHITA ELECTRON CORP), 25 February 2000 (2000-02-25)
- DATABASE WPI Section EI, Week 200330 Derwent Publications Ltd., London, GB; Class U11, AN 2003-306168 XP002394349 -& JP 2003 077915 A (MATSUSHITA DENKI SANGYO KK) 14 March 2003 (2003-03-14)

## Description

The present invention relates to a plasma processing apparatus and a plasma processing method suitably usable for applying various kinds of plasma processing to a processing target in order to manufacture an electronic device and the like.

A plasma processing apparatus described herein is widely applicable to plasma processing in general, typically, to manufacturing of a semiconductor or materials of electronic devices such as a semiconductor device and a liquid crystal device, but for descriptive convenience, a background art of a semiconductor device will be described here as an example.

Generally, in manufacturing processes of a semiconductor device, various kinds of processing such as CVD (Chemical Vapor Deposition) processing, etching processing, and sputtering processing are applied to a semiconductor device substrate (wafer) being a processing target.

Conventionally, a plasma processing apparatus is often used for such various kinds of processing. This is because the use of the plasma processing apparatus is advantageous in that chemical reaction, which occurred only at high temperature in a conventional art, can be caused at low temperature by using a nonequilibrium low-temperature plasma.

Recent miniaturization of a semiconductor device has given rise to a strong demand for a device with a thinner film structure. For example, in a semiconductor device structure of a MOS type which is the most popular as the structure of the semiconductor device, there has been a high need for an extremely thin (for example, on the order of 2 nm or less) and high-quality gate insulation film according to so-called scaling rule.

Conventionally, the use of a plasma (for example, an inductively coupled plasma (ICP), a microwave plasma, or the like) has been in the mainstream in the formation or processing (oxidation processing, nitridation processing, or the like) of such a gate insulation film.

However, in accordance with the aforesaid trend toward a thinner film structure of the device, there often arise problems of damage that has conventionally been of substantially no significance, in particular, damage to a processing target ascribable to electrons, ions, and/or ultraviolet light generated by the plasma.

The occurrence of such damage to the processing target tends to cause new problems such as poor breakdown voltage of the gate insulation film, increased leakage current, and reduced transistor driving current.
Reference is also directed to DATABASE WPI Section Ch, Week 200022 Derwent Publication Ltd., London, GB; Class L03, AN 2000-249337 XP 002394348 (=JP 2000-058292), which relates to plasma processing apparatus using high frequency discharge. High frequency pulse power of high and low level for plasma generation is supplied continuously or intermittently to a whorl-like electrode in a chamber from a power supply. A vacuum UV light source and cylindrical ends are provided to the side of the chamber. When high-frequency pulse power of low level for plasma generation is supplied, vacuum UV light is irradiated from the light source to the plasma generation area through the cylindrical lens. Unstable discharge is prevented by adjusting high frequency pulse power suitably. Deterioration of device character can be prevented, as directed irradiation of energy bear is prevented.
Reference is also directed to DATABASE WPI Section E1, Week 200330 Derwent Publications Ltd., London, GB; Class U11, AN 2003-306168 XP002394349 (=JP 2003-077915), which discloses a method for forming an insulating film for semiconductor integrated circuits, which involves forming a silicon oxynitride film on a semiconductor wafer and applying high frequency electric power for plasma generation. High frequency electric power for plasma generation is applied intermittently during film formation so as to control persistence of ions in the nitrogen plasma. By supplying electric power to the plasma intermittently, the damage of the insulating film can be suppressed and reliability of the film is improved.
U.K. Patent application No. GB 2 349 506 A, discloses a plasma etching method wherein a pulse modulated RF bias of 2-5MHz (power off time of 10-100 microseconds and power on time of about 20 microseconds) is applied to an etching gas including bromie or hydrogen bromide. The etching gas may also comprise mixtures of bromine or hydrogen bromide with gases comprising chlorine, nitrogen, oxygen, and carbon. The etching gas is selected according to its electronegativity and negative ion generation cross section compared to chlorine. The etching method is used for high precision patterning of polysilicon or titanium or tungsten gate electrodes.

It is an object of the present invention to provide a plasma processing apparatus and a plasma processing method overcoming the aforesaid drawbacks of the conventional art.

It is another object of the present invention to provide a plasma processing apparatus and a plasma processing method that realize suitable plasma processing with reduced damage to a processing target ascribable to plasma generation.

As a result of assiduous studies, the present inventors have found out that it is remarkably effective for achieving the objects stated above that a processing target is given a plasma generated based on energy that is supplied intermittently (namely, at predetermined intervals), instead of a plasma generated based on energy that is supplied continuously (or using a continuous wave) as in the conventional art.

The above findings are the basis of the plasma processing apparatus of the present invention.
According to a first aspect of the present invention, there is provided a plasma processing apparatus according to claim 1. According to a second aspect of the present invention, there is provided a plasma processing method according to claim 8.
For a better understanding of the present invention, there is also described in the following a plasma processing apparatus including at least: a plasma processing chamber in which plasma processing is applied to a processing target; a processing target supporting means for setting the processing target in the plasma processing chamber; and a plasma generating means for generating a plasma in the plasma processing chamber, wherein the plasma generating means is capable of generating the plasma based on intermittent energy supply.

Further, there is described in the following a plasma processing method of applying plasma processing to a processing target by using a plasma processing apparatus including at least: a plasma processing chamber in which the plasma processing is applied to the processing target; a processing target supporting means for setting the processing target in the plasma processing chamber; and a plasma generating means for generating a plasma in the plasma processing chamber, wherein the plasma is generated based on intermittent energy supply while the processing target supporting means holds the processing target, thereby applying the plasma processing to the processing target.

Using the above-described techniques, a radical efficiently generated by the plasma generation based on the intermittently supplied energy (a microwave, RF, or the like) from the plasma generating means is supplied to the processing target, so that it is possible to substantially reduce electron temperature of the plasma processing, with substantially no deterioration in efficiency of the plasma processing.

In addition, because of reduced ion bombardment and reduced charge-up damage, it is also possible to substantially reduce damage to the processing target ascribable to ions and/or ultraviolet light from the plasma generated based on the intermittent energy supply. Therefore, it is possible to perform predetermined plasma processing (for example, plasma nitridation and/or plasma oxidation processing), with substantially no deterioration in efficiency of the plasma processing.

On the other hand, in conventional plasma processing, even when a plasma with relatively low electron temperature (for example, ECR plasma or the like) is used, the electron temperature of the plasma is about 2 to 4 eV, and therefore, giving a plasma generated based on continuous energy supply to a processing target involves a high possibility of causing damage to the processing target. Therefore, using the techniques described herein, it is possible to reduce the damage to the processing target compared with the conventional art.

As described above, using the techniques described herein it is possible to provide a plasma processing apparatus and a plasma processing method that realize suitable plasma processing with reduced damage to a processing target ascribable to plasma generation. Therefore, applying these techniques to, for example, deposition processing of an insulation film makes it possible to prevent the occurrence of problems ascribable to the damage, such as poor breakdown voltage of the insulation film, increased leakage current, and reduced transistor driving current.

[FIG. 1] A schematic cross-sectional view showing a plasma processing apparatus according to an embodiment of the present invention.
[FIG 2] A schematic cross-sectional view showing an example of a detailed configuration of the plasma processing apparatus shown in FIG 1.
[FIG. 3] Data of graphs showing a decrease in electron temperature and so on achieved by pulses.
[FIG. 4] Data of graphs showing a decrease in electron temperature and so on achieved by pulses.
[FIG. 5] Data of graphs showing a decrease in electron temperature and so on achieved by pulses.

The reference signs used in the figures denote the following features:
- 100: plasma processing apparatus
- 101: plasma processing chamber
- 102: mounting table
- 104: insulating plate
- 105: planar antenna member
- 105a: slots
- 106: retardation member
- 107: coaxial waveguide
- 108: microwave generator
- 120: controller
- 121: modulator

Hereinafter, the present invention will be more concretely described, with reference to the drawings when necessary. In the description below, "part" and "%" representing a quantity ratio are on a mass basis unless otherwise noted.

### (Plasma processing apparatus)

A plasma processing apparatus according to an embodiment of the present invention includes at least the features of claim 1. Thus, inter alia, a plasma processing chamber in which plasma processing is applied to a processing target; a processing target supporting means for setting the processing target in the plasma processing chamber; and a plasma generating means for generating a plasma in the plasma processing chamber. In this plasma processing apparatus, the plasma generating means is capable of generating the plasma based on intermittent energy supply.

### (Intermittent energy supply)

Herein "intermittent energy supply" means that an instant at which energy supply for plasma generation becomes zero takes place at least once in a predetermined time range (for example, 1 millisecond). As long as the "intermittent energy supply" takes place, a form of "intermittent" is not limited to a specific form. That is, a waveform for the energy supply may be any of known waveforms such as a rectangular waveform, a triangular waveform, and a curved waveform (for example, a sine curve). The "intermittent energy supply" preferably takes place based on the combination of a rectangular wave and a high-frequency wave.

In view of balancing between plasma generation efficiency and reduction in damage to the processing target, the total time in which the energy supply for plasma generation becomes zero is preferably 20 to 200 µ seconds, and more preferably, 50 to 100 µ seconds, in 1000 millisecond period.

### (Modulation)

The aforesaid "intermittent energy supply" may be given in a time-modulation manner when necessary.

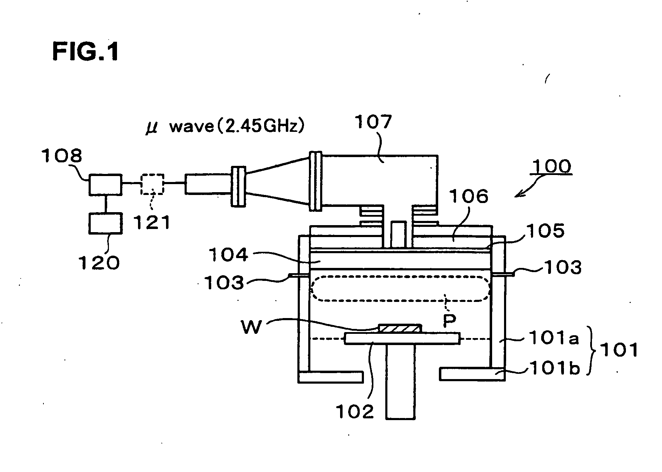

FIG. 1 is a schematic cross-sectional view showing a plasma processing apparatus according to an embodiment of the present invention. This example describes a case where the plasma processing apparatus is applied to plasma CVD (Chemical Vapor Deposition) processing. When the apparatus shown in FIG 1 is used for other plasma processing (for example, plasma oxidation and/or plasma nitridation processing), process gas is not supplied from, for example, a later-described processing gas supply nozzle 103. Incidentally, in the example shown in FIG 1, a planar antenna member 105 is used as an antenna member.

As shown in FIG. 1, this plasma processing apparatus 100 has a plasma processing chamber 101 in a cylindrical shape as a whole, with a sidewall 101a and a bottom portion 101b thereof, for example, being made of conductors such as aluminum, and an inner part of the plasma processing chamber 101 is formed as an airtight processing space S.

This plasma processing chamber 101 houses a mounting table 102 for placing a processing target (for example, a semiconductor wafer W) on an upper surface thereof. This mounting table 102 is made of, for example, anodized aluminum or the like and formed in a substantially columnar shape that is protruding and flat.

On the upper surface of the aforesaid mounting table 102, an electrostatic chuck or a clamping mechanism (not shown) for keeping the wafer W held on the upper surface is provided. Further, the mounting table 102 is connected to a matching box (not shown) and a high-frequency power source for bias (for example, for 13.56 MHz; not shown) via a feeder (not shown). Note that in a case of CVD (that is, when the bias is not applied), this high-frequency power source for bias need not be provided.

Meanwhile, in the sidewall of the aforesaid plasma processing chamber 101, the aforesaid gas supply nozzle 103 for introducing vapor-containing gas into a vessel is provided as a gas supply means.

A ceiling portion of the plasma processing chamber 101 has an opening, in which an insulating plate 104 (for example, about 20 mm in thickness) made of a ceramic material such as, for example, quartz or Al₂O₃ and transmissive for a microwave is airtightly provided via a sealing member (not shown) such as an O-ring.

On an upper surface of this insulating plate 104, the disk-shaped planar antenna member 105 and a retardation member 106 (made of quartz, Al₂O₃, AiN, or the like) having a high dielectric-constant property are provided. A microwave propagates to the planar antenna member 105 from a coaxial waveguide 107. The frequency of the microwave is not limited to 2.45 GHz but other frequency, for example, 8.35 GHz may be used.

The microwave is generated by, for example, a microwave generator 108. The microwave generator 108 intermittently outputs the microwave, for example, in a pulsed manner, under the control by a controller 120 controlling ON-OFF thereof, and supplies the microwave to the coaxial waveguide 107. In a background example not being covered by the present invention, instead of such ON-OFF control, a modulator 121 may time-modulates the microwave from the microwave generator 108 to intermittently supply energy of the microwave to the coaxial waveguide 107.

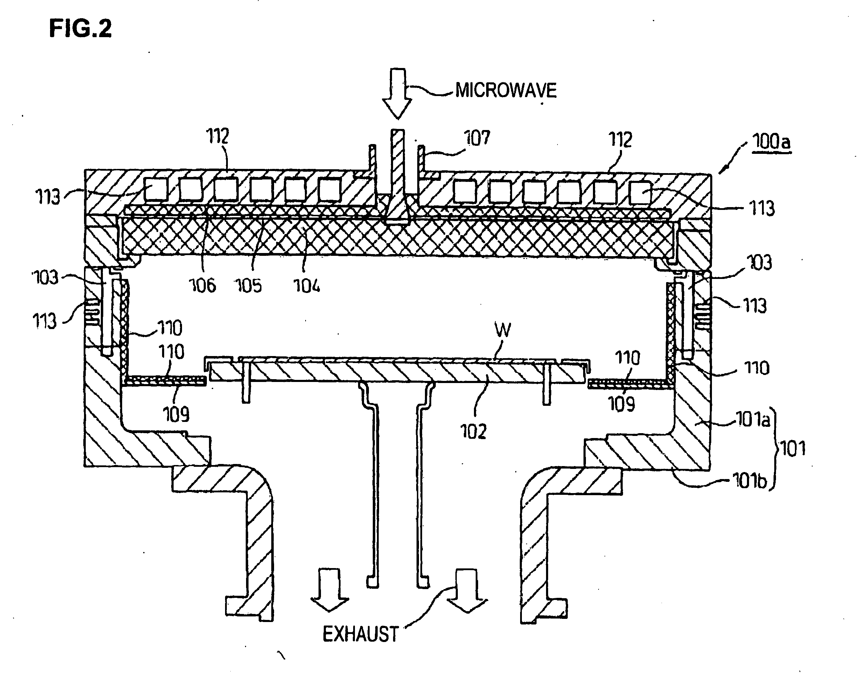

FIG 2 is a schematic cross-sectional view showing a more detailed example of the configuration shown in FIG 1. As shown in FIG 2, this plasma processing apparatus 100a has a plasma processing chamber 101 in a cylindrical shape as a whole, with a sidewall 101a and a bottom portion 101b thereof, for example, being made of conductors such as aluminum, and an inner part of the plasma processing chamber 101 is formed as an airtight processing space.

This plasma processing chamber 101 houses a mounting table (stage) 102 for placing a processing target (for example, a semiconductor wafer W) on an upper surface thereof. This mounting table 102 has therein a heater (not shown) for heating the wafer W when necessary.

Meanwhile, in the sidewall of the aforesaid plasma processing chamber 101, the aforesaid gas supply nozzle 103 for introducing vapor-containing gas into a vessel is provided as a gas supply means. In FIG 2, a gas baffle plate 109 is disposed to be substantially perpendicular to the sidewall 101a for the purpose of uniform gas exhaust. Further, in the sidewall 101a and in the gas baffle plate 109, liners 110 made of, for example, quartz glass are disposed for preventing the occurrence of particles from the walls.

In an opening of a ceiling portion of the plasma processing chamber 101, an insulating plate 104 (for example, about 20 mm in thickness) made of a ceramic material such as, for example, quartz or Al₂O₃ and transmissive for a microwave is airtightly provided via a sealing member (not shown) such as an O-ring.

On an upper surface of this insulating plate 104, a disk-shaped planar antenna member 105 and a retardation member 106 (for example, made of quartz, Al₂O₃, AiN, or the like) having a high dielectric-constant property are provided. As the planar antenna member 105, used is a RLSA (Radial Line Slot Antenna) in which a plurality of slots 105a are formed, for example, circularly or spirally. Further, owing to a wavelength shortening effect of the retardation member 106 having the high dielectric-constant property, the guide wavelength of the microwave can be shortened.

In FIG. 2, a cooling plate 112 for cooling the retardation member 106 and so on is disposed on the retardation member 106, and refrigerant paths 113 are provided inside the cooling plate 112 and the sidewall 101 a in order to cool these members. The microwave (with the frequency of 2.45 GHz or the like) propagates to the aforesaid planar antenna member 105 from a coaxial waveguide 107, as described above.

Next, an example of a processing method using the plasma processing apparatus as structured above will be described.

Referring to FIG. 2, first, a carrier arm (not shown) sets a semiconductor wafer W in the plasma processing chamber 101 via a not-shown gate valve 68, and lifter pins (not shown) are moved up/down to place the wafer W on the upper surface of the mounting table 102. With a process pressure inside the plasma processing chamber 10 being kept at a predetermined value, for example, within a range from 0.01 to several Pa, argon gas, for instance, is supplied from a plasma gas supply nozzle (not shown) at a controlled flow rate, and at the same time, deposition gas such as, for example, SiH₄, O₂, or N₂ is supplied from the process gas supply nozzle 103 at a controlled flow rate. At the same time, the microwave from the microwave generator 108 is intermittently supplied to the planar antenna member 105 via the coaxial waveguide 107, and the microwave whose wavelength is shortened by the retardation member 106 is introduced into the processing space S to generate a plasma, whereby predetermined plasma processing, for example, film deposition processing by plasma CVD is performed.

### (Structures of the respective parts)

The structures of the respective parts shown in FIG 1 and FIG. 2, materials usable in the apparatuses shown in FIG 1 and FIG. 2, and so on will be described.

### (Substrate for an electronic device)

The aforesaid substrate for an electronic device is not limited to a specific one, but one kind or the combination of two kinds or more among known substrates for electronic devices can be appropriately selected for use. Examples of such substrates for electronic devices are a semiconductor material, a liquid crystal device material, and so on. Examples of the semiconductor material are a material mainly made of single-crystal silicon and a material mainly made of silicon germanium, and examples of the liquid crystal device material are polysilicon, amorphous silicon, and so on deposited on a glass substrate.

### (Process gas)

The process gas is not limited to specific one. That is, in oxidation processing of the electronic device substrate in an embodiment of the present invention, at least oxygen gas or gas containing oxygen atoms is usable as the process gas without any special limitation. In nitridation processing of the electronic device substrate in an embodiment of the present invention, at least nitrogen gas or gas containing nitrogen atoms is usable as the process gas without any special limitation. Moreover, in CVD processing, known deposition gas is usable without any special limitation.

### (Examples of suitable process gas)

Examples of suitable process gases and flow rates thereof are shown below.
(1) Oxidation processing
   Ar/O₂ = 1000/10 to 1000/100 sccm
(2) Nitridation processing
   Ar/N₂ = 1000/10 to 1000/200 sccm
(3) CVD
   Ar/C₄F₈ = 1000/20 to 1000/400 sccm

### (Rare gas)

Rare gas usable for plasma generation is not limited to specific one, but one kind or the combination of two kinds or more among well-know rare gases usable in electronic device manufacture can be appropriately selected for use. Example of such process gas are krypton (Kr), xenon (Xe), helium (He), and argon (Ar).

### (Conditions of process gas)

In forming an oxynitride film using a method embodying the present invention, the following conditions are suitably adopted in view of characteristics of a film to be formed.
(1) Flow rate of the rare gas (for example, Kr, Ar, He, or Xe): 200 to 1000 sccm, more preferably, 500 to 1000 sccm
(2) Flow rate of the process gas: 10 to 100 sccm, more preferably, 20 to 50 sccm
(3) Temperature: room temperature (25°C) to 500°C, more preferably, 250 to 400°C
(4) Pressure in the process chamber: 5 to 300 Pa, more preferably, 6 to 150 Pa
(5) Microwave: 0.5 to 3 W/cm², more preferably, 0.7 to 1.5 W/cm² (ON/OFF of the microwave is preferably 10 to 100 KHz, and Duty ratio is preferably 20% to 80%).

### (Suitable plasma)

Characteristics of a suitable plasma are as follows.
(1) Electron temperature: 0.5 to 1.0 eV
(2) Density: 1 to 20 x 10¹¹/cm³
(3) Uniformity of plasma density: ±10%

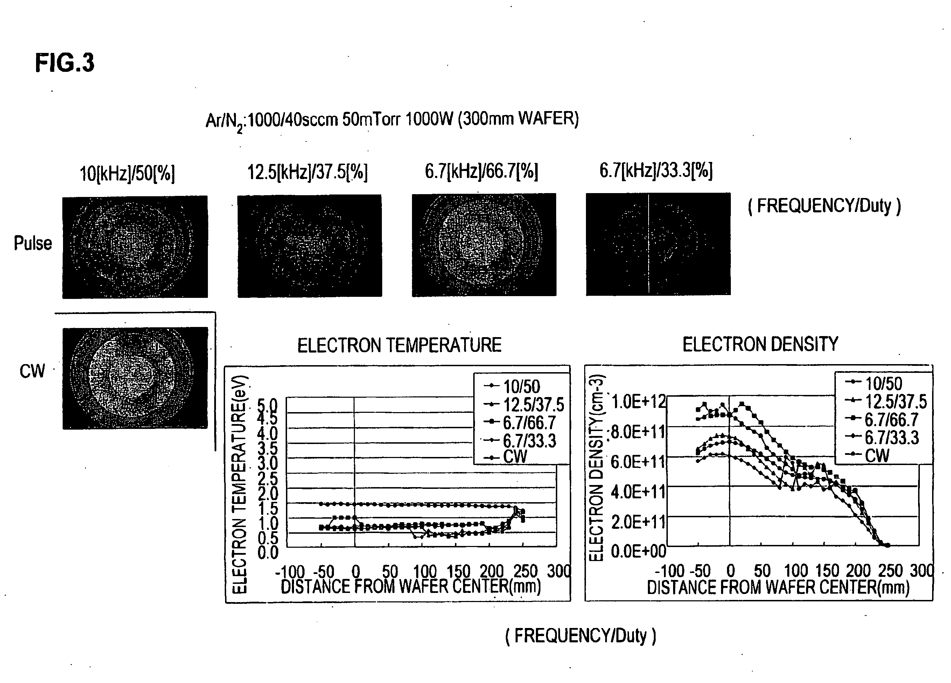

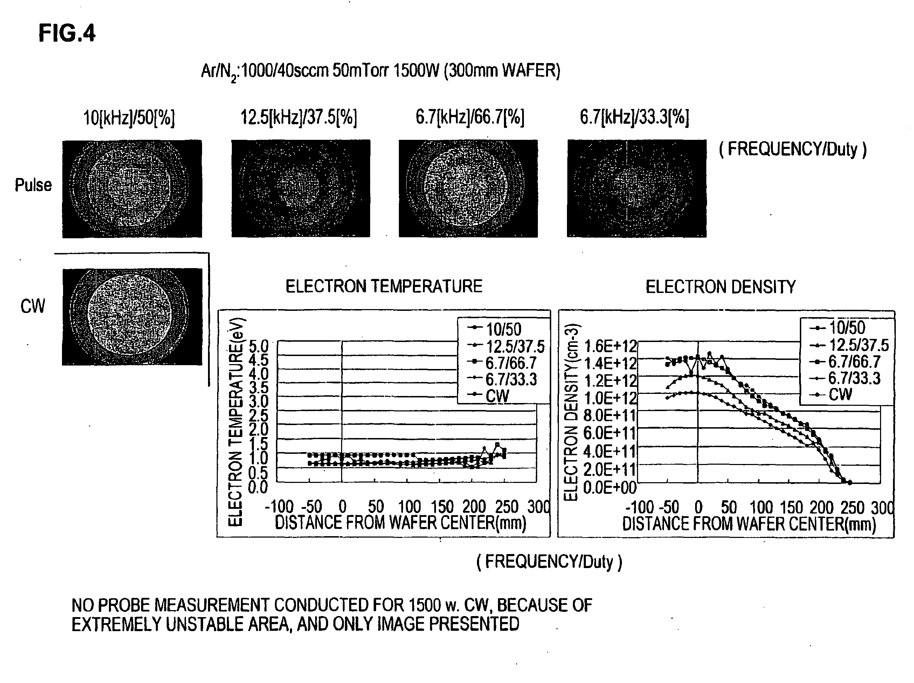

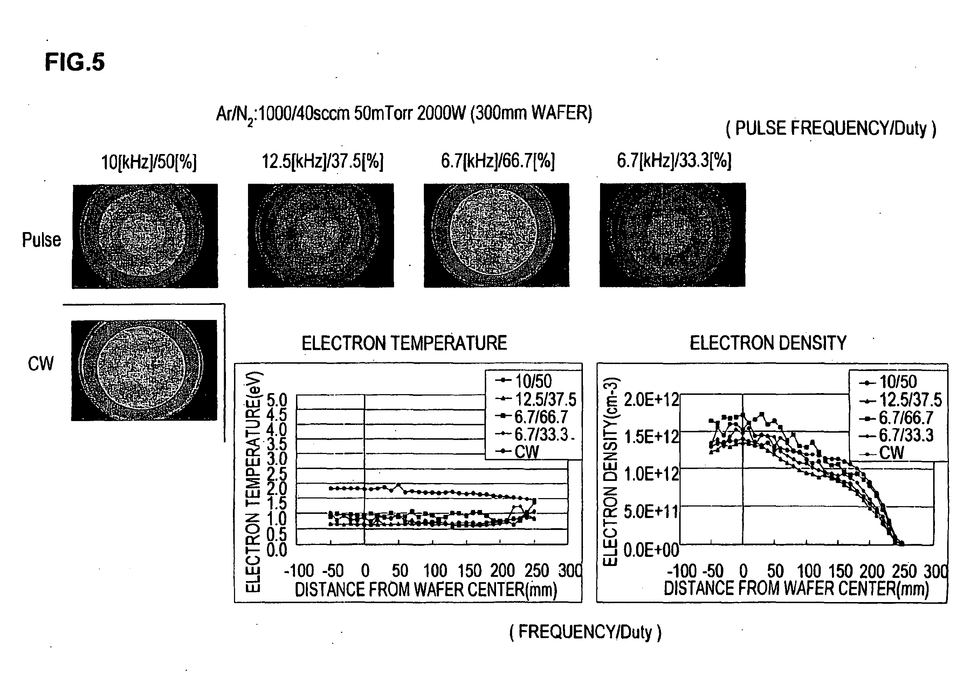

FIG. 3 to FIG 5 show results of the electron temperature and the electron density in a wafer from its center to edge, when plasma processing was applied based on continuous energy supply using a continuous wave (CW) and when plasma processing was applied based on intermittent energy supply using pulses. Conditions and so on for these data are shown in the drawings. The conditions in all the processing in FIG 3 to FIG 5 were set such that flow rate of Ar/N₂: 1000/40 sccm and pressure in the process chamber: 50 mTorr (1 Torr = 133 Pa), with varied plasma powers of 1000 W (the example in FIG 3), 1500 W (the example in FIG 4), and 2000 W (the example in FIG 5). In each of the cases, the frequency/Duty of the pulse was set in four different ways for study, namely, 10 [kHz]/50[%], 12.5 (kHz)/37.5[%], 6.7 [kHz]/66.7%, and 6.7 [kHz]/33.3[%].

As is apparent from these results, the electron temperature can be made lower in the processing by the plasma generated based the intermittent energy supply according to an embodiment of the present invention than in the processing by the plasma generated based on the continuous energy supply using the continuous wave. In addition, as for the electron density, a higher density is achieved than in the case of the continuous wave. Therefore, it is possible to realize high-quality plasma processing with reduced damage to the processing target.

### (Other plasma)

In the above-described embodiment, the plasma generation using the microwave is described, but the plasma generating means (plasma source) is not limited to a specific one as long as the energy is intermittently supplied. That is, besides the microwave, ICP (inductively coupled plasma) is also usable.

### (Other application)

In the above-described embodiment, the case where the film deposition processing is applied to the semiconductor wafer is described as an example, but this is not restrictive, and the techniques described herein are also applicable to other plasma processing such as plasma etching processing and plasma ashing processing. Further, the processing target is not limited to the semiconductor wafer, and a glass substrate, a LCD (liquid crystal device) substrate, and the like can also be used.

## Claims

1. A plasma processing apparatus for applying plasma nitridation processing and/or plasma oxidation processing or plasma CVD processing or plasma ashing processing to a processing target, comprising at least:
a plasma processing chamber (101) with a sidewall (101a) and a bottom portion (101b) made of conductors;
a processing target supporting means (102) for setting the processing target in the plasma processing chamber;
a heater in the processing target supporting means for heating the plasma processing target;
an insulating plate (104) airtightly sealing an opening of a ceiling portion of the plasma processing chamber via a sealing member;
a gas supply means (103) for introducing a process gas into the plasma processing chamber;
an antenna member (105) disposed on an upper surface of the insulating plate;
a microwave generator (108) connected to the antenna member (105) for generating a plasma of the process gas in the plasma processing chamber; and
a controller (120) connected to the microwave generator (108) and adapted to control the microwave generator (108) to generate the plasma based on intermittent energy supply by ON-OFF control, **characterised in that**
the controller (120) is operable to control the plasma of the process gas to have an electron temperature of 0.5 to 1 eV based on intermittent energy supply into the plasma processing chamber by ON-OFF control of the microwave generator (108).

2. A plasma processing apparatus according to claim 1, wherein
a liner (110) made of quartz glass is disposed in the sidewall of the plasma processing chamber (101).

3. A plasma processing apparatus according to Claim 1, further comprising:
a gas baffle plate (109) adapted to exhaust an inside of the plasma processing chamber (101).

4. A plasma processing apparatus according to claim 3, wherein
the insulating plate (104) is made of a quartz or ceramic material.

5. A plasma processing apparatus according to either claim 3 or claim 4, wherein
the antenna member (105) is a planar antenna member having a plurality of slots.

6. A plasma processing apparatus according to any one of claims 3 to 5, wherein
the processing target supporting means (102) has an electrostatic chuck or a clamping mechanism.

7. A plasma processing apparatus according to any one of claims 3 to 6, wherein
a bias power source is connected to the processing target supporting means (102).

8. A plasma processing method for applying plasma nitridation processing and/or plasma oxidation processing or plasma CVD processing or plasma ashing processing to a processing target, using a plasma processing apparatus (100) and comprising the steps of:
employing a plasma processing chamber (101) to apply plasma processing to the processing target;
employing a processing target supporting means (102) to set the processing target in the plasma processing chamber (101);
heating the processing target supporting means (102) to heat the plasma processing target;
providing an insulating plate (104) to airtightly seal an opening of a ceiling portion of the plasma processing chamber (101) via a sealing member;
introducing process gas into the plasma processing chamber (101);
employing an antenna member (105) disposed on an upper surface of the insulating plate (104);
connecting a microwave generator (108) to the antenna member to generate a plasma of the process gas in the plasma processing chamber (101); and
controlling the microwave generator (108) to generate the plasma based on intermittent energy supply by ON-OFF control, **characterised by**
controlling the plasma of the process gas to have an electron temperature of 0.5 to 1 eV based on intermittent energy supply into the plasma processing chamber by ON-OFF control of the microwave generator (108).

9. A plasma processing method according to claim 8, comprising the steps of:
supplying, in the plasma processing, rare gas and oxygen gas for forming the plasma into the plasma processing chamber (101);
generating the plasma by intermittent energy supply; and
applying plasma oxidation processing to the processing target.

10. A plasma processing method according to either claim 8 or claim 9, comprising the steps of:
supplying, in the plasma processing, rare gas and nitrogen gas for forming the plasma into the plasma processing chamber (101);
generating the plasma by intermittent energy supply, and applying plasma nitridation processing to the processing target.

11. A plasma processing method according to claim 8, comprising the steps of:
generating the plasma by the intermittent energy supply by controlling the microwave generator (108) in the plasma processing;
supplying rare gas and nitrogen gas; and
applying oxynitride processing to the processing target by the plasma to form an oxynitride film.

12. A plasma processing method according to any one of claims 8 to 11, wherein
the rare gas comprises at least one of Ar, Kr, He, and Xe.

13. A plasma processing method according to claim 11, or according to claim 12 when not dependent upon claims 9 or 10, comprising:
controlling a pulse of the intermittently supplied energy to have a pulse frequency within a range of 10 kHz to 100 kHz and a duty ratio within a range of 20% to 80%.

14. A plasma processing method according to any one of claims 8 to 13, wherein
the energy is supplied from an antenna member (105) including a planar antenna having a plurality of slots.

## Patentansprüche

1. Plasmaverarbeitungsgerät zum Anwenden einer Plasmanitrierungsverarbeitung und/oder einer Plasmaoxidationverarbeitung oder einer Plasma-CVD-Verarbeitung oder einer Plasmaätzverarbeitung auf ein Verarbeitungsziel, mit zumindest:
einer Plasmaverarbeitungskammer (101) mit einer Seitenwand (101a) und einem Bodenteil (101b), das aus Leitern hergestellt ist;
einer Verarbeitungszielunterstützungsvorrichtung (102) zum Setzen des Verarbeitungsziels in die Plasmaverarbeitungskammer;
einem Heizer in der Verarbeitungszielunterstützungsvorrichtung zum Heizen des Plasmaverarbeitungsziels;
einer isolierenden Platte (104), die luftdicht eine Öffnung eines Dachteils der Plasmaverarbeitungskammer über ein Dichtteil abdichtet;
einer Gaszuführvorrichtung (103) zum Einführen eines Prozessgases in die Plasmaverarbeitungskammer;
einem Antennenteil (105), das auf einer oberen Oberfläche der isolierenden Platte angeordnet ist;
einem Mikrowellenerzeuger (108), der mit dem Antennenteil (105) verbunden ist, zum Erzeugen eines Plasmas des Prozessgases in der Plasmaverarbeitungskammer; und
einem Steuergerät (120), das mit dem Mikrowellenerzeuger (108) verbunden ist und angepasst ist, den Mikrowellenerzeuger (108) zu steuern, um das Plasma basierend auf einer intermittierenden Energiezufuhr durch EIN-AUS-Steuerung zu erzeugen, **dadurch gekennzeichnet, dass**
das Steuergerät (120) betriebsfähig ist, das Plasma des Prozessgases zu steuern, um eine Elektronentemperatur von 0.5 bis 1 eV basierend auf einer intermittierenden Energiezufuhr in die Plasmaverarbeitungskammer durch EIN-AUS-Steuerung des Mikrowellenerzeugers (108) aufzuweisen.

2. Plasmaverarbeitungsgerät nach Anspruch 1, wobei
ein Einsatz (110), der aus Quartzglas hergestellt ist, in der Seitenwand der Plasmaverarbeitungskammer (101) angeordnet ist.

3. Plasmaverarbeitungsgerät nach Anspruch 1, weiter mit:
einer Gasscheideplatte (109), die angepasst ist, ein Inneres der Plasmaverarbeitungskammer (101) zu entleeren.

4. Plasmaverarbeitungsgerät nach Anspruch 3, wobei die isolierende Platte (104) aus einem Quartz- oder keramischen Material hergestellt ist.

5. Plasmaverarbeitungsgerät nach entweder Anspruch 3 oder 4, wobei
das Antennenteil (105) ein ebenes Antennenteil mit einer Vielzahl von Schlitzen ist.

6. Plasmaverarbeitungsgerät nach einem der Ansprüche 3 bis 5, wobei die Verarbeitungszielunterstützungsvorrichtung (102) eine elektrostatische Aufspannvorrichtung oder einen Klammermechanismus aufweist.

7. Plasmaverarbeitungsgerät nach einem der Ansprüche 3 bis 6, wobei eine Vorspannungsleistungsquelle mit der Verarbeitungszielunterstützungsvorrichtung (102) verbunden ist.

8. Plasmaverarbeitungsverfahren zum Anwenden einer Plasmanitrierungsverarbeitung und/oder einer Plasmaoxidationverarbeitung oder einer Plasma-CVD-Verarbeitung oder einer Plasmaätzverarbeitung auf ein Verarbeitungsziel, unter Verwendung eines Plasmaverarbeitungsgerätes (100) und mit den Schritten:
Verwenden einer Plasmaverarbeitungskammer (101), um eine Plasmaverarbeitung auf das Verarbeitungsziel anzuwenden;
Verwenden einer Verarbeitungszielunterstützungsvorrichtung (102), um das Verarbeitungsziel in die Plasmaverarbeitungskammer (101) zu setzen;
Heizen der Verarbeitungszielunterstützungsvorrichtung (102), um das Plasmaverarbeitungsziel zu heizen;
Bereitstellen einer isolierenden Platte (104), die luftdicht eine Öffnung eines Dachteils der Plasmaverarbeitungskammer (101) über ein Dichtteil abdichtet;
Einführen eines Prozessgases in die Plasmaverarbeitungskammer (101);
Verwenden eines Antennenteils (105), das auf einer oberen Oberfläche der isolierenden Platte (104) angeordnet ist;
Verbinden eines Mikrowellenerzeugers (108) mit dem Antennenteil, um ein Plasma des Prozessgases in der Plasmaverarbeitungskammer (101) zu erzeugen; und
Steuern des Mikrowellenerzeugers (108), um das Plasma basierend auf einer intermittierenden Energiezufuhr durch EIN-AUS-Steuerung zu erzeugen, **gekennzeichnet durch**
Steuern des Plasmas des Prozessgases zu steuern, um eine Elektronentemperatur von 0.5 bis 1 eV basierend auf einer intermittierenden Energiezufuhr in die Plasmaverarbeitungskammer **durch** EIN-AUS-Steuerung des Mikrowellenerzeugers (108) aufzuweisen.

9. Plasmaverarbeitungsverfahren nach Anspruch 8,
Zuführen bei der Plasmaverarbeitung von Edelgas und Stauerstoffgas zum Bilden des Plasmas in die Plasmaverarbeitungskammer (101);
Erzeugen des Plasmas durch intermittierende Energiezufuhr; und
Anwenden einer Plasmaoxidationsverarbeitung auf des Verarbeitungsziel.

10. Plasmaverarbeitungsverfahren nach Anspruch 8 oder 9, weiter mit den Schritten:
Zuführen bei der Plasmaverarbeitung von Edelgas und Stickstoffgas zum Bilden des Plasmas in die Plasmaverarbeitungskammer (101);
Erzeugen des Plasmas durch intermittierende Energiezufuhr; und
Anwenden einer Plasmanitrierungsverarbeitung auf des Verarbeitungsziel.

11. Plasmaverarbeitungsverfahren nach Anspruch 8 , mit den Schritten:
Erzeugen des Plasmas durch die intermittierende Energiezufuhr durch Steuern des Mikrowellenerzeugers (108) bei der Plasmaverarbeitung;
Zuführen von Edelgas und Stickstoffgas; und
Anwenden einer Oxinitridverarbeitung auf das Verarbeitungsziel durch das Plasma, um einen Oxinitrdfilm zu erzeugen.

12. Plasmaverarbeitungsverfahren nach einem der Ansprüche 8 bis 11, wobei das Edelgas zumindest eines aus Ar, Kr, He, und Xe umfasst.

13. Plasmaverarbeitungsverfahren nach Anspruch 11, oder nach Anspruch 12, wenn nicht abhängig von Anspruch 9 oder 10, mit:
Steuern eines Pulses der intermittierend zugeführten Energie, um eine Pulsfrequenz innerhalb eines Bereiches von 10 kHz bis 100 kHz und einen Tastgrad innerhalb eines Bereiches von 20% bis 80% aufzuweisen.

14. Plasmaverarbeitungsverfahren nach einem der Ansprüche 8 bis 13, wobei die Energie von einem Antennenteil (105) einschließlich einer ebenen Antenne mit einer Vielzahl von Schlitzen zugeführt wird.

## Revendications

1. Appareil de traitement par plasma pour appliquer un traitement de nitruration par plasma et/ou un traitement d'oxydation par plasma ou un traitement CVD au plasma ou un traitement de décollement au plasma à une cible de traitement, comprenant au moins :
une chambre de traitement par plasma (101) avec une paroi latérale (101a) et une partie formant fond (101b) faites de conducteurs ;
un moyen de support de cible de traitement (102) pour positionner la cible de traitement dans la chambre de traitement par plasma ;
un dispositif de chauffage dans le moyen de support de cible de traitement pour chauffer la cible de traitement par plasma ;
une plaque isolante (104) scellant hermétiquement une ouverture d'une partie formant plafond de la chambre de traitement par plasma par l'intermédiaire d'un élément d'étanchéité ;
un moyen d'alimentation en gaz (103) pour introduire un gaz de processus dans la chambre de traitement par plasma ;
un élément d'antenne (105) disposé sur une surface supérieure de la plaque isolante ;
un générateur hyperfréquence (108) relié à l'élément d'antenne (105) pour générer un plasma du gaz de processus dans la chambre de traitement par plasma ; et
une unité de commande (120) reliée au générateur hyperfréquence (108) et conçue pour commander le générateur hyperfréquence (108) pour générer le plasma sur base d'une alimentation en énergie intermittente par une commande MARCHE-ARRÊT, **caractérisée en ce que**
l'unité de commande (120) peut être mise en oeuvre pour commander le plasma du gaz de processus afin qu'il ait une température d'électron de 0,5 à 1 eV sur base d'une alimentation en énergie intermittente dans la chambre de traitement par plasma par une commande MARCHE-ARRÊT du générateur hyperfréquence (108).

2. Appareil de traitement par plasma selon la revendication 1, dans lequel
un revêtement (110) fait de verre de quartz est disposé dans la paroi latérale de la chambre de traitement par plasma (101).

3. Appareil de traitement par plasma selon la revendication 1, comprenant en outre :
un déflecteur de gaz (109) conçu pour évacuer un intérieur de la chambre de traitement par plasma (101).

4. Appareil de traitement par plasma selon la revendication 3, dans lequel
la plaque isolante (104) est faite d'un quartz ou d'une matière céramique.

5. Appareil de traitement par plasma selon la revendication 3 ou la revendication 4, dans lequel
l'élément d'antenne (105) est un élément d'antenne plan ayant une pluralité de fentes.

6. Appareil de traitement par plasma selon l'une quelconque des revendications 3 à 5, dans lequel
le moyen de support de cible de traitement (102) a un mandrin électrostatique ou un mécanisme de serrage.

7. Appareil de traitement par plasma selon l'une quelconque des revendications 3 à 6, dans lequel
une source de courant de polarisation est reliée au moyen de support de cible de traitement (102).

8. Procédé de traitement par plasma pour appliquer un traitement de nitruration par plasma et/ou un traitement d'oxydation par plasma ou un traitement CVD au plasma ou un traitement de décollement au plasma à une cible de traitement, en utilisant un appareil de traitement par plasma (100) et comprenant les étapes consistant à :
employer une chambre de traitement par plasma (101) pour appliquer un traitement par plasma à la cible de traitement ;
employer un moyen de support de cible de traitement (102) pour positionner la cible de traitement dans la chambre de traitement par plasma (101) ;
chauffer le moyen de support de cible de traitement (102) pour chauffer la cible de traitement par plasma ;
fournir une plaque isolante (104) pour hermétiquement sceller une ouverture d'une partie formant plafond de la chambre de traitement par plasma (101) par l'intermédiaire d'un élément d'étanchéité ;
introduire un gaz de processus dans la chambre de traitement par plasma (101) ;
employer un élément d'antenne (105) disposé sur une surface supérieure de la plaque isolante (104) ;
relier un générateur hyperfréquence (108) à l'élément d'antenne pour générer un plasma du gaz de processus dans la chambre de traitement par plasma (101) ; et
commander le générateur hyperfréquence (108) pour produire le plasma sur base d'une alimentation en énergie intermittente par une commande MARCHE-ARRÊT,
**caractérisé par**
la commande du plasma du gaz de processus pour qu'il ait une température d'électron de 0,5 à 1 eV sur base d'une alimentation en énergie intermittente dans la chambre de traitement par plasma par une commande MARCHE-ARRÊT du générateur hyperfréquence (108).

9. Procédé de traitement par plasma selon la revendication 8, comprenant les étapes consistant à :
fournir, dans le traitement par plasma, un gaz rare et un gaz d'oxygène pour former le plasma dans la chambre de traitement par plasma (101) ;
générer le plasma par une alimentation en énergie intermittente ; et
appliquer un traitement d'oxydation par plasma à la cible de traitement.

10. Procédé de traitement par plasma selon la revendication 8 ou la revendication 9, comprenant les étapes consistant à :
fournir, dans le traitement par plasma, un gaz rare et un gaz d'azote pour former le plasma dans la chambre de traitement par plasma (101) ;
générer le plasma par une alimentation en énergie intermittente et appliquer un traitement de nitruration par plasma à la cible de traitement.

11. Procédé de traitement par plasma selon la revendication 8, comprenant les étapes consistant à :
générer le plasma par l'alimentation en énergie intermittente en commandant le générateur hyperfréquence (108) dans le traitement par plasma ;
fournir un gaz rare et un gaz d'azote ; et
appliquer un traitement d'oxynitrure à la cible de traitement par le plasma pour former un film d'oxynitrure.

12. Procédé de traitement par plasma selon l'une quelconque des revendications 8 à 11, dans lequel
le gaz rare comprend au moins l'un de Ar, Kr, He et Xe.

13. Procédé de traitement par plasma selon la revendication 11, ou selon la revendication 12 quand elle ne dépend pas des revendications 9 ou 10, comprenant :
la commande d'une impulsion de l'énergie fournie par intermittence pour qu'elle ait une fréquence d'impulsion dans une plage de 10 kHz à 100 kHz et un facteur de service dans une plage de 20 % à 80 %.

14. Procédé de traitement par plasma selon l'une quelconque des revendications 8 à 13, dans lequel
l'énergie est fournie en provenance d'un élément d'antenne (105) incluant une antenne plane ayant une pluralité de fentes.
